# EUROPEAN PATENT SPECIFICATION

(11) **EP 2 144 274 B1**
(45) Date of publication and mention of the grant of the patent: **12.09.2012**
(21) Application number: 08159924.3
(22) Date of filing: 08.07.2008
(51) Int. Cl.: H01J 37/073, H01J 37/08, H01J 1/304, H01J 9/02, H01J 27/26, C25D 5/48, C25D 7/00, G01Q 70/16, B81C 1/00, B82Y 15/00

(54) **Method of preparing an ultra sharp tip and use of an apparatus therefor**
Verfahren zur Herstellung einer extrem scharfen Spitze und Verwendung einer Vorrichtung hierzu
Procédé de préparation d'une pointe très vive et utilisation correspondante d'un appareil

(43) Date of publication of application: 13.01.2010
(73) Proprietor: ICT Integrated Circuit Testing Gesellschaft für Halbleiterprüftechnik mbH, 85551 Heimstetten (DE)
(72) Inventor: Winkler, Dieter, 81737 München (DE); Weigel, Udo, 80796 München (DE); Grimm, Stefan, 85551 Kirchheim (DE)
(74) Representative: Zimmermann & Partner

(56) References cited:
- US-A- 4 774 414
- US-A1- 2006 075 626
- US-A1- 2007 228 287
- ITAGAKI E ET AL: "Atomic-scale field emitter with self-repairable function and thermodynamically stable structure: FEM study on Pd-covered nanopyramids on W<111> tips" D SURFACE SCIENCE, ELSEVIER, AMSTERDAM, NL, vol. 251, no. 1-4, 15 September 2005 (2005-09-15), pages 205-209, XP005014285 ISSN: 0169-4332
- FU ET AL: "Study of two types of Ir or Rh covered single atom pyramidal W tips" SURFACE SCIENCE, NORTH-HOLLAND PUBLISHING CO, AMSTERDAM, NL, vol. 601, no. 18, 20 September 2007 (2007-09-20), pages 3992-3995, XP022259481 ISSN: 0039-6028
- TSU-YI FU ET AL: "Method of creating a Pd-covered single-atom sharp W pyramidal tip: Mechanism and energetics of its formation" PHYSICAL REVIEW, B. CONDENSED MATTER, AMERICAN INSTITUTE OF PHYSICS. NEW YORK, US, vol. 64, no. 11, 15 September 2001 (2001-09-15), pages 113401/1-113401/4, XP002439455 ISSN: 0163-1829
- HONG-SHI KUO ET AL: "Noble Metal/W(111) Single-Atom Tips and Their Field Electron and Ion Emission Characteristics" JAPANESE JOURNAL OF APPLIED PHYSICS, JAPAN SOCIETY OF APPLIED PHYSICS, TOKYO,JP, vol. 45, no. 11, 8 November 2006 (2006-11-08), pages 8972-8983, XP007903666 ISSN: 0021-4922
- KUO H-S; HWANG I-S; FU T-Y; LIN Y-C; CHANG C-C; TSONG T T: "Preparation of single-atom tips and their field emission behaviors" E-JOURNAL OF SURFACE SCIENCE AND NANOTECHNOLOGY, vol. 4, 17 February 2006 (2006-02-17), pages 233-238, XP002507289 Japan ISSN: 1348-0391
- SONG KER-JAR ET AL: "Faceting of W(111) induced by ultrathin Pd films" LANGMUIR 1991 DEC, vol. 7, no. 12, December 1991 (1991-12), pages 3019-3026, XP002507290 & DATABASE COMPENDEX [Online] ENGINEERING INFORMATION, INC., NEW YORK, NY, US; Database accession no. EIX92030440312

## Description

### FIELD OF THE INVENTION

The invention generally relates to a method of preparing an ultra sharp tip and use of an apparatus therefor. More specifically, it relates to a method of preparing an ultra sharp tip, in particular a single atom tip and use of an apparatus in a method for preparing an ultra sharp tip, in particular a single atom tip.

### BACKGROUND OF THE INVENTION

Technologies such as microelectronics, micromechanics and biotechnology have created a high demand for structuring and probing specimens within the nanometer scale. On such a small scale, probing or structuring is often performed with electron or charged particle beams which are generated in electron or charged particle sources. Electron beams and charged particle beams, in particular ion beams, offer superior spatial resolution compared to photon beams, due to their short wave lengths at comparable particle energy.

For creating electron or charged particle beams, ultra sharp tips are utilized for instance in electron or ion source applications, including, but not limited to high resolution electron beams or gas field ion microscopes. Some ultra sharp tips may even have an apex formed of a single atom, and are referred to as single atom tips (SAT).

One known process to prepare ultra sharp tips or single atom tips is based on adsorbate induced faceting of tips, for instance of metal tips. Such ultra sharp metal tips may typically be base tips covered with a thin coating of a metal other than the metal of the base tip. For example, some known ultra sharp tips are tungsten tips covered with a thin layer of noble metal materials, e.g. Pt, Rh, Pd, and Ir.

Adsorbate induced faceting is typically performed by a heating step at temperatures high enough to allow for the adsorbate, e.g. the metal coating, to rearrange and low enough to prevent evaporation of the adsorbate and/or rearrangement of the base tip. For example in case of a single crystal base tip, the faceting of the tip results from an adjustment of the adsorbate crystal lattice to the lattice parameter of the base tip. Thus, the tip may form for instance a pyramid and, hence, an ultra sharp tip or even a single atom tip. However, the adjustment of the adsorbate structure to the structure of the base tip may be affected by contaminants. Therefore, the formation of such an ultra sharp tip requires complex cleaning procedures prior to deposition of the coating and faceting, as well as a highly clean environment.

Different processes to deposit the coating on the base tips are known, e.g. electroplating or vapor deposition. In these processes, it is necessary to carefully clean the tips prior to deposition. For example, in case of electroplating, tips are usually cleaned by etching in the same watery environment prior to the deposition step. For a vapor deposition process, usually tips have to be carefully cleaned by heat cleaning or field evaporation and the coating material deposition has to be performed in a highly clean environment. Both processes require detailed knowledge and control of the parameters as well as a dedicated setup. Furthermore, the surfaces of such produced ultra sharp tips may include steps and protrusions, resulting in a surface roughness which may affect the performance of the tip in subsequent applications.

The document "Atomic-scale field emitter with self-repairable function and thermodynamically stable structure: FEM study on Pd-covered nanopyramids on W<111> tips" by E. Rokuta and T. Itagaki et al., Applied Surface Science, Vol. 251 (2005), Nr. 1-4, pages 205 - 209, discloses a method of preparing an ultra sharp tip, in particular a single atom tip, including the steps of providing a tip having a shank, an apex, and a coating covering the shank and the apex; exposing the apex by locally removing the coating from the apex by field evaporation; and partially or fully restoring the coating at the apex.

### SUMMARY OF THE INVENTION

In light of the above, a method of preparing an ultra sharp tip according to independent claim 1 and a use according to claim 11 are provided.

Further advantages, features, aspects, and details are evident from the dependent claims, the description and the drawings.

The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features of the present invention can be understood in detail, a more particular description of embodiments of the invention, briefly summarized above, may be had by reference to examples. Some of the above mentioned embodiments will be described in more detail in the following description of typical examples and embodiments with reference to the following drawings in which:

Figs. 1a and 1b show examples of an apparatus for preparing an ultra sharp tip, according to examples useful for understanding the invention.

Figs. 2a to 2c illustrate typical intermediates and a typical product of an example of a method of preparing an ultra sharp tip according to examples useful for understanding the invention.

Figs. 3a to 3c illustrate typical intermediates and a typical product of an example of a method of preparing an ultra sharp tip according to examples useful for understanding the invention.

Figs. 4a to 4c illustrate typical intermediates and a typical product of an example of a method of preparing an ultra sharp tip according to examples useful for understanding the invention.

Figs. 5a to 5d illustrate typical intermediates and typical products of an example of a method of preparing an ultra sharp tip according to examples useful for understanding the invention.

Figs. 6a to 6c illustrate typical intermediates and a typical product of an example of a method of preparing an ultra sharp tip according to embodiments disclosed herein.

Figs. 7a to 7d illustrate typical intermediates and a typical product of an example of a method of preparing an ultra sharp tip according to embodiments disclosed herein.

Figs. 8a to 8e illustrate typical intermediates and a typical product of an example of a method of preparing an ultra sharp tip according to embodiments disclosed herein.

Figs. 9a to 9e illustrate typical intermediates and a typical product of an example of a method of preparing an ultra sharp tip according to embodiments disclosed herein.

### DETAILED DESCRIPTION OF THE DRAWINGS

Reference will now be made in detail to the various examples and embodiments, one or more examples of which are illustrated in the figures. Each example is provided by way of explanation, and is not meant as a limitation of the invention.

Typical applications of the ultra sharp tip according to embodiments described herein are in beam emitters of electron sources, ion sources, gas field ion sources, ion beam pattern generators, field ion microscopes (FIM), and electron microscopes, as well as in scanning tunneling microscopes (STM).

Without limiting the scope of the present disclosure, the following is directed to a method, an apparatus and use of an apparatus for preparing an ultra sharp tip, which may even be formed as a single atom tip (SAT).

Within the following description of the drawings, the same reference numbers refer to the same components. Furthermore, for the sake of clarity, in some of the figures atoms and contaminants are illustrated having proportions which do not reveal the actual atomic proportions of the chemical elements and contaminants mentioned in the corresponding examples of embodiments. Generally, only the differences with respect to the individual examples or embodiments are described.

According to one example useful for understanding the invention, an apparatus for preparing an ultra sharp tip, in particular a single atom tip, comprises a vacuum chamber comprising a tip support, a field evaporation device adapted for performing a field evaporation at a tip provided at the tip support, and a coating restoring device.

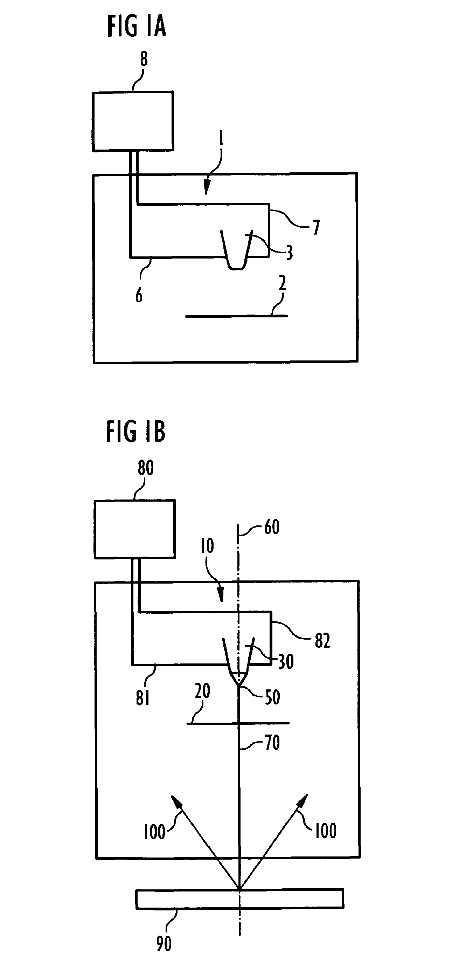

Fig. 1a shows schematically an apparatus for preparing an ultra sharp tip. The apparatus typically includes a vacuum chamber 1 provided with vacuum pumps (not shown) and process gas inlets (not shown), in which a field evaporation device 2 and a tip support 3 is installed. On tip support 3 precursor tips may be installed, from which the ultra sharp tips may be formed according to embodiments described herein. Furthermore, in this example, tip support 3 is typically connected via connections 6 and 7 to a current supply 8 for applying a high voltage, e.g. about 10 k V to about 50 kV, typically about 30 kV, as well as a heating current, e.g. 2 A, to a tip mounted thereon. Since by using current supply 8 a tip mounted at the tip support may be heated, annealing of the tip may be performed. Therefore in the present example, the current supply 8 may be used as the coating restoring device. The field evaporation device 2 is typically formed as a conductive plate on which a high voltage, e.g. about 1 kV to about 30 kV, typically about 20 kV, may be applied. Thereby, an extremely high electric field between a tip mounted at the tip support 3 and the conductive plate 2 may be established , resulting for instance in a potential difference between the tip and the conductive plate of about 1 kV to about 50 kV, typically about 10 kV.

According to one example useful for understanding the invention of a method of preparing an ultra sharp tip, in particular a single atom tip, the method comprises providing a tip having a shank, an apex, and a coating covering the shank and the apex; locally removing the coating from the apex by field evaporation; and partially or fully restoring the coating at the apex. Thereby, a simplification may be achieved using a standard equipment and/or standard base tips in the initial step of providing a covered base tip. Further, the subsequent preparation steps of field evaporation and restoring of the coating at the apex can be done in one vacuum setup, which, in addition, may be provided separately from the equipment used for the initial step of providing a covered base tip. In addition, the steps of field evaporation and restoring of the coating at the apex may be performed in situ, typically in a vacuum setup and/or at a tip position which are used for a later application of the ultra sharp tip, e.g. in a charged particle column. For instance, the steps of field evaporation and restoring of the coating at the apex may be performed directly in a column in which imaging processes using the ultra sharp tip are performed, e.g. probing and/or structuring of a specimen. More typically, at least the steps of locally removing and partially or fully restoring may be performed while the tip is provided in a charged particle column, the tip being provided in a position to perform probing or structuring of a specimen. To this end, the tip may e.g. be provided in a charged particle beam source which is installed in a charged particle column in a position to perform probing or structuring of a specimen. As a result, the method may simply be performed using standard coating devices and standard installations for application of an ultra sharp tip.

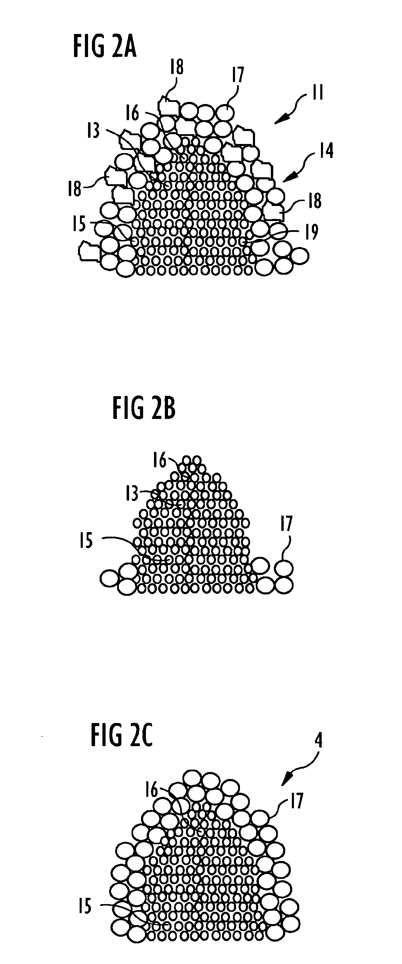

In one typical example of a method according to examples useful for understanding the invention disclosed herein, typical intermediates and a typical product thereof being illustrated in Fig. 2a, a precursor tip 11 formed of a tungsten base tip 13 covered by a thin platinum layer 14 is provided in a first step (Fig. 2a). The base tip 13 may consist of a tungsten tip including a shank 15 and an apex 16 and may typically be a tip suitable for field emission applications, for instance a commercial tungsten tip for electron or ion sources. Fig. 2a shows the uppermost part of the precursor tip 11. The platinum coating 14 including platinum atoms 17 may be applied on the tungsten base tip 13 by appropriate deposition techniques, such as physical vapor deposition or electroplating. The coating process may be performed in standard deposition installations and does not require extremely high clean conditions before and during the deposition process. The thin platinum layer 14 produced thereby may have a thickness of up to a few nm, and may e.g. include about 1 to 10 layers of platinum atoms 17. Because of the deposition in standard installations, the uppermost layers of the tungsten base tip 13 and the platinum layer 14 may include contaminants 18, such as oxides, and surface steps. The platinum covered tungsten tip 11 (also referred to herein as precursor tip) so produced may have an apex radius of, for example, about 10 nm. After coating, the precursor tip 11 is then transferred into the above mentioned apparatus for preparing an ultra sharp tip, which includes a vacuum chamber including a tip support, a field evaporation device adapted for performing a field evaporation at a tip provided at the tip support, and a coating restoring device. The precursor tip 11 may for instance be installed at the tip support 3 of the apparatus shown in Fig. 1a, the precursor tip 11 facing the conductive plate 2.

In a further step of the present example, a field evaporation process is performed. To this end, after installation of the platinum covered tungsten tip 11 at the tip support 3 of the apparatus shown in Fig. 1a, the vacuum chamber 1 is evacuated to a vacuum pressure or even a high vacuum pressure, e.g. up to 10⁻⁶ Torr (133·10⁻⁶ Pa). A high voltage of e.g. about 12 kV is applied to the precursor tip 11 using current supply 8, while a high voltage of e.g. about 1 kV is applied to the conductive plate 2. Thereby, an extremely high electrical field of about a few or a few tens V/nm, for instance in a range of about 10 to about 50 V/nm, is established between the precursor tip 11 and the conductive plate 2 for a time period, e.g. up to a few minutes, such as 1 to 5 minutes. As a result, surface atoms of the precursor tip 11 are ionized and evaporated, thereby releasing platinum surface atoms 17 and contaminants 18 from the surface and exposing the apex 16 of the tungsten base tip 13. Hence, the apex 16 of the tungsten base tip 13 is not only exposed, but also cleaned using the field evaporation process. In a variation of the present example, depending on the electric field strength and the duration of applying the electric field to the precursor tip 11, also tungsten atoms 19 and, if present, contaminants of the uppermost layers of the tungsten base tip 13 may be released and evaporated. The surface area of the precursor tip 11, which may be involved in the field evaporation process at the apex, may for instance include up to about 300 nm². The person skilled in the art will know or can easily determine the time period or the time intervals for applying the electric field to the precursor tip 11, in order to achieve the desired evaporation effect. Since in the field evaporation process mainly the atom layers of the apex of the precursor tip 11 are involved, platinum atoms 17 are left at the shank 15 of the base tip 13 after termination of the field evaporation process, as shown in Fig. 2b.

In a subsequent step of the present example, current supply 8 may be regulated to supply a heating current to the tip support 3, thereby heating the tip up to a temperature in a range of about 500 to 1300 K, typically about 1100 K, and thereby annealing the base tip 13 having platinum atoms 17 at the shank 15. The heating may be controlled such that diffusion of platinum atoms into the bulk of the base tip and formation of a bulk alloy is avoided. Therefore, the annealing may be performed by one or more short heating pulses of a duration of less than a second or by continuously heating the tip for 1 sec to a few minutes, e.g. about 1 - 360 sec. Consequently, platinum atoms 17 at the shank 15 are mobilized and migrate to the apex 16 of the base tip 13. As a result and because of the wettability of tungsten by platinum, the apex is recovered with a platinum coating. Furthermore, the platinum coating may be rearranged during annealing to flatten the atomic surface of the platinum covered tip, thereby minimizing kinks and steps of the surface of the ultra sharp tip at the apex and/or the shanks thereof. Thereby, an extremely clean platinum covered tungsten tip is produced and, in addition, the surface roughness thereof may be minimized, resulting in an atomic smooth ultra sharp tip. Further, because of the high temperatures during annealing, adsorbate induced faceting may be induced. This is due to a rearrangement of the adsorbate, i. e. in this example of the platinum coating, to adjust the crystal lattice of the platinum coating to the lattice of the underlying tungsten layers or to the lattice of underlying domains, respectively, of the tungsten base tip 13. Furthermore, the heating temperatures are regulated to not exceed the melting point of platinum and tungsten, and, hence, evaporation of the platinum atoms at the tip surface and/or rearrangement of the base tip are prevented. Thus, during restoring, e.g. 1 to 10 layers of platinum atoms may be arranged as a coating on the apex of the base tip, the latter being in the present example formed as initially provided. As a consequence of the adsorbate induced faceting, the resulting platinum covered tungsten tip may have a regularly formed platinum covered apex, for instance a pyramid, and an ultra sharp tip 4 is produced. In some cases, even a single atom tip (SAT) may be produced by the method according to the present example, resulting in a coating having only one platinum atom at the uppermost apex of the ultra sharp tip. In a variation of examples or embodiments disclosed herein, also the upper layers of the base tip may be rearranged during adsorbate induced faceting, thus promoting the formation of an ultra sharp or SAT tip.

In a variation of the present example and of other examples or embodiments disclosed herein, the apparatus for preparing an ultra sharp tip may additionally include a device for monitoring the tip 11. By this device, the tip quality may be observed when performing the method of preparing an ultra sharp tip according to embodiments disclosed herein. Such a device for monitoring the tip may be, for example, a device for measuring the emission current. For instance, the device may be adapted to measure the angular distribution of the emission from the tip. This may be accomplished for example by deflecting and detecting the particles emitted from the tip using a deflector, an aperture and a detector. Alternatively, the device may be a mass spectrometer for detecting which sort of particles are emitted from the tip, e.g. during field evaporation. In another example, a field ion microscope may be used for monitoring and control of the tip quality.

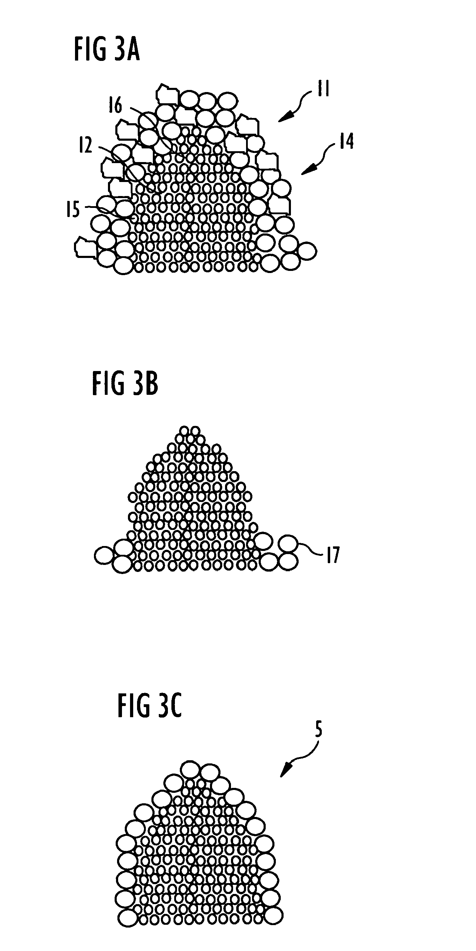

The formation of an ultra sharp tip or a single atom tip as illustrated above may be improved by using a single crystal base tip, for instance a single crystal tungsten tip. Such a variation of the above example may result in intermediates and a product schematically shown in Fig. 3a to 3c. Initially, a precursor tip 11 with a tungsten single crystal base tip 12 including a single atom tip may be provided, as illustrated in Fig. 3a. However, also a precursor tip having a single crystal base tip including more than one atom at the uppermost apex may be utilized. The steps of locally removing the coating and fully or partially restoring the coating at the apex correspond to the steps as described for the above example. Thereby, an intermediate exposed base tip as shown in Fig. 3b and a final ultra sharp tip, for instance a single atom tip 5 coated with a platinum monolayer as illustrated in Fig. 3c may be formed. The effect of using a single crystal base tip is that the platinum layers of the restored coating of the ultra sharp tip may include crystal faces revealing or being influenced by the crystal structure of the underlying tungsten single crystal. Hence, by using a single crystal base tip, the adsorbate induced faceting is promoted. Thereby, the apex of the ultra sharp tip may be formed as a part of a crystalline polyhedron, for instance as a pyramid, which may be energetically privileged as assessed by thermodynamic considerations. Hence, the preparation of an ultra sharp or even of a single atom tip may be encouraged using a single crystal base tip.

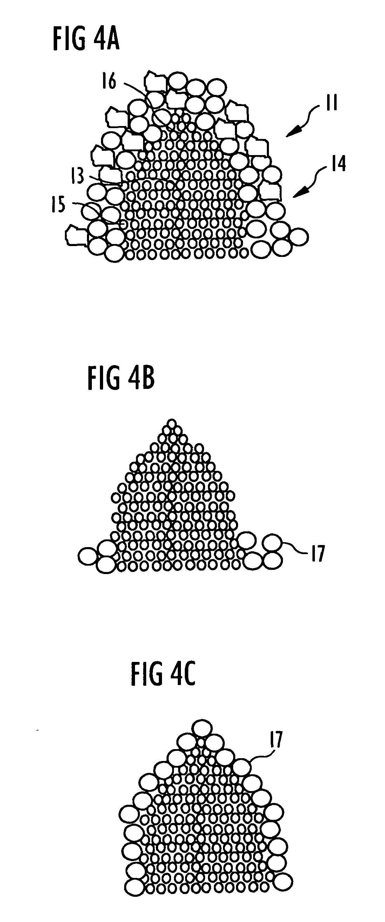

As already mentioned above referring to Fig. 3c, in a variation of the above example of a method described herein, the partial of full restoring may be performed such that at least a monolayer of the coating is formed on the apex. Typical intermediates and a typical product thereof are illustrated in Figs. 4a to 4c. The steps of providing a precursor tip covered by a coating and locally removing the coating, the typical intermediates thereof being shown in Fig. 4a and 4b, correspond to the steps illustrated in Fig. 2a and 2b. However, the step of restoring the coating at the apex may be performed just partially. For example, departing from a platinum coating 14 having initially about 10 atomic layers adsorbed on the tungsten base tip 13, the exposed apex of the base tip (Fig. 4b) may be recovered by a platinum coating having less than 10 layers, for example to result in a monolayer of platinum atoms 17, as shown in Fig. 4c. This can for instance be achieved by applying a reduced heating current or by applying only one or more short heating pulses to the tip, as will be understood by the skilled person.

Alternatively, for instance in case that the platinum is provided as a protective coating confined to the shank of the ultra sharp tip, according to another typical example of the method disclosed herein, the step of annealing may be performed such that only a part of a platinum monolayer is restored at the apex. The uppermost apex of the resulting ultra sharp tip or single atom tip may in this case include base tip atoms. This partial restoring can be done, depending on the materials of the base tip and the covering layer, for example by using only one or more heating pulses, typically of a temperature of about 1100 K and a duration of less than a second up to a few seconds. Thereby, the platinum atoms, which remained on the shank of the tip after the field evaporation process, may be rearranged on the shank and mobilized and migrate to the apex just to such an extent that the uppermost apex of the base tip is not covered by platinum atoms.

For continuously heating the tip or for achieving short heating pulses, the annealing may typically be performed by resistance heating, e.g. by applying a heating current as mentioned above, or may alternatively be performed by laser irradiation. Therefore, in a variation of the above mentioned apparatus for preparing an ultra sharp tip, the coating restoring device may be a laser arranged such that the tip may be irradiated and heated. Moreover, the coating restoring device may optionally include a deposition device for adsorbing additional platinum atoms at the apex of the exposed base tip, for instance by physical vapor deposition. In this case, the restoring may be performed just by adsorbing further platinum atoms at the apex of the base tip, optionally while the tip is heated, or by a combination of platinum deposition and subsequent annealing. Hence, the step of partially or fully restoring may be performed by at least one step selected from the group consisting of heating by applying a current to the tip, heating by laser irradiation, and deposition of additional coating material.

As explained above, the examples and embodiments described herein provide a simplified method of preparing an ultra sharp tip. Embodiments of the method include a combination of field evaporation to locally remove the covering layer, i.e. the coating, at the apex and thereby cleaning the base tip, and a subsequent partial or full restoration of the covering layer. In one step, covered base tips are provided, for instance by covering commercial tips for electron or ion source applications with a thin layer, e.g. a layer of noble metal, with standard deposition devices. No complex cleaning is needed before and after the deposition. Then in a further step, field evaporation is applied to the covered tip. Since field evaporation depends on the species of materials adsorbed on or incorporated in the tip, it can locally remove preferably the covering layer at the apex, the possible contaminants and, in some cases, it can also remove partly the base tip atoms, resulting in an atomically clean tip surface at the apex. With a yet further step, layer atoms from the shank of the tip are mobilized, e.g. by annealing using an appropriate heating current applied to the tip. As a result, the mobilized covering layer atoms start wetting the surface of the tip again and restoring the thin layer in the area where the covering previously was removed. Furthermore, the surface roughness of the ultra sharp tip may be minimized, resulting in an atomic smooth ultra sharp tip. Simplification is achieved by the use of standard equipment and/or of standard base tips in the initial step of providing a covered base tip. Further, the subsequent preparation steps of field evaporation and restoring of the coating at the apex can be done in one vacuum setup, e.g. in the apparatus schematically shown in Fig. 1a. In addition, the steps of field evaporation and restoring of the coating at the apex may be performed in situ, typically in a vacuum setup and/or at a tip position which are used for a later application of the ultra sharp tip, e.g. in a charged particle column. More typically, at least the steps of locally removing and partially or fully restoring may be performed while the tip is provided in a charged particle column, the tip being provided in a position to perform probing or structuring of a specimen.

According to other examples of the method according to embodiments disclosed herein, in the step of locally removing the coating, the apex may be further shaped, e.g. by at least one step selected from the group consisting of thermally induced shaping and flattening by field evaporation.

Thermally induced shaping may be performed e.g. by an annealing step before, during or after the step of locally removing the coating from the apex by field evaporation. Alternatively, the field evaporation may be performed discontinuously, the thermally induced shaping being effected e.g. by one or more intermediate annealing steps.

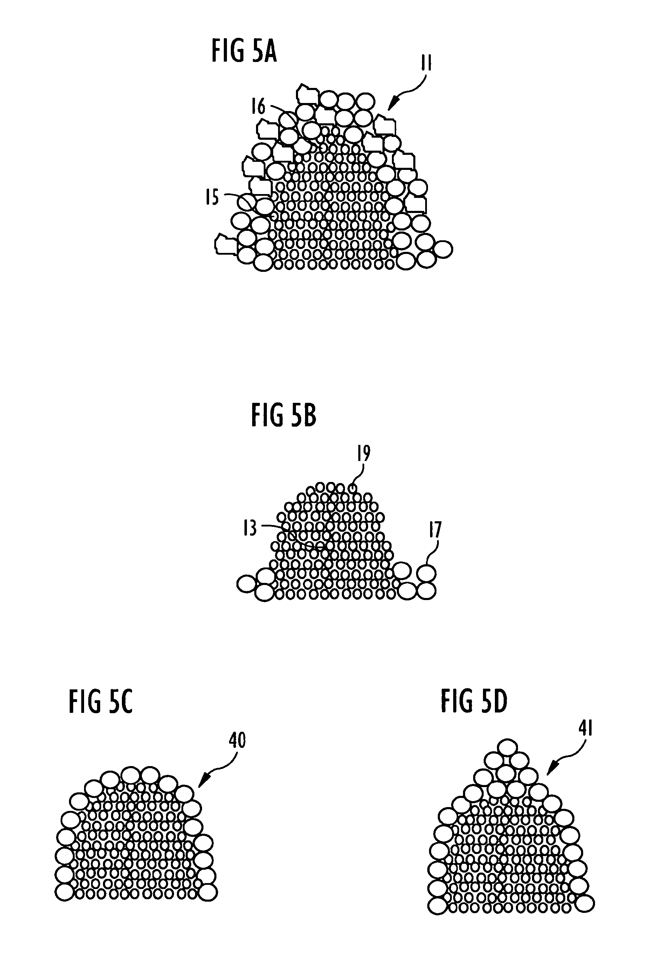

Typical intermediates and a typical product of another example are schematically shown in Figs. 5a to 5c. This example differs from the example illustrated in Figs. 2a to 2c by shaping the apex of the base tip during field evaporation via flattening of the exposed base tip 13. This may be typically achieved by varying, e.g. increasing, the electrical field between the exposed apex of the base tip 13 and the conductive plate 2 of the apparatus 1 for preparing an ultra sharp tip shown in Fig. 1a. Alternatively or in addition, applying the electrical field for a longer time period may result in evaporating tungsten atoms 19 from the surface of the exposed base tip 13 during field evaporation. After finishing the restoring step, in which in this example a monolayer of platinum atoms may be established on the base tip 13, an flattened ultra sharp tip 40 covered by a monolayer of platinum atoms is formed, as shown in Fig. 5c. In a variation of this example, e.g. by further annealing during the restoring step, at the flattened exposed base tip 13 a pyramid of platinum atoms may be formed, resulting for instance in a single atom tip 41 as shown in Fig. 5d. The formation of a platinum pyramid may be due to energetically privileged epitaxial growth of the platinum layers on the flattened base tip and/or due to thermodynamically preferred adsorbate induced faceting, e.g. a rearrangement of the adsorbate layer and/or the uppermost layers of the tungsten base tip.

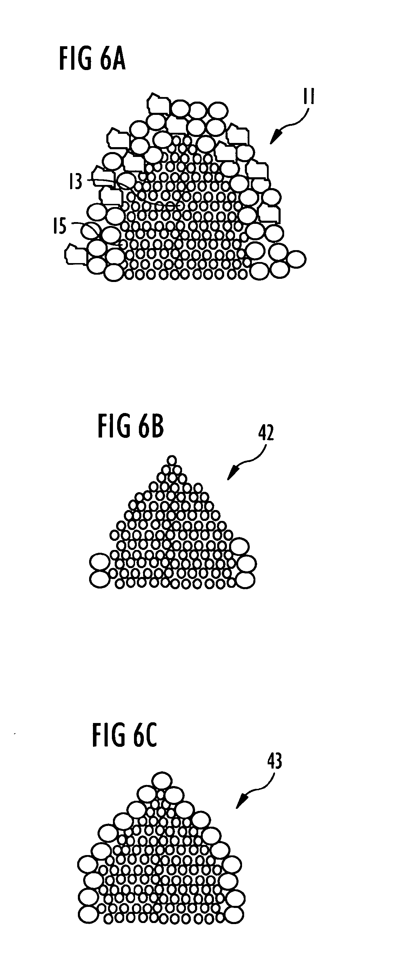

In another example of the method according to embodiments disclosed herein and illustrated in Figs. 6a to 6c, in the step of locally removing the coating at the apex, the latter is shaped by sharpening, using spatially controlled field-assisted etching. Such sharpening may be performed for instance using a field assisted etching by reaction with N₂. This approach is based on spatially controlling the reaction of nitrogen gas with the surface atoms of the exposed tungsten base tip in an electrical field applied between the exposed base tip 13 and e.g. the conductive plate 2 shown in Fig. 1a and confining this etching reaction to the lateral surface of the apex of the base tip. Thereby, as shown in Fig. 6b, a single atom base tip 42 with an apex radius of less than 10 nm may be formed, the process also being called a nanotip formation. In the subsequent restoring step, a monolayer of platinum atoms may be formed on the single atom apex of the etched base tip, resulting in a monolayer covered single atom tip 43 shown in Fig. 6c.

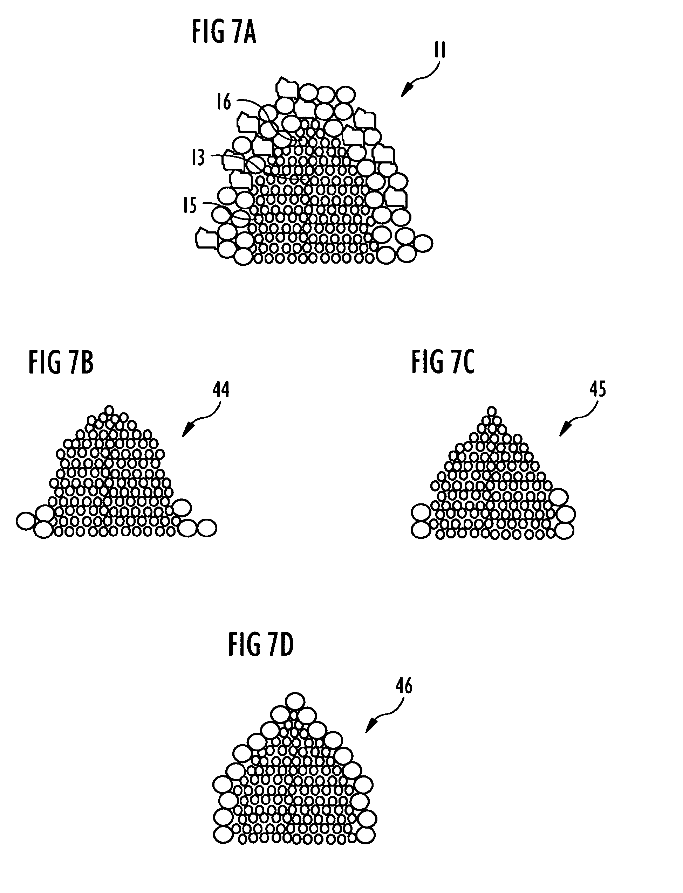

According to a further example of the method according to embodiments disclosed herein, the apex may be shaped by both steps of flattening by field evaporation and sharpening by spatially controlled field-assisted etching. That means the steps described above referring to the intermediates shown in Fig. 5b and 6b are combined in a method of preparing an ultra sharp tip, possible intermediates and a possible product thereof being illustrated in Fig. 7a to 7d. In detail, after providing the platinum coated base tip 11 shown in Fig. 7a, field evaporation is performed, thereby removing the platinum coating and the contaminants from the apex 16 of the base tip 13. Then field evaporation is continued until the upper tungsten layers of the base tip 13 are evaporated, resulting in a flattened base tip 44 as shown in Fig. 7b. After that, a field assisted etching by reaction with N₂ is performed as described above for the example illustrated in Fig. 6a to 6c. Thereby, tungsten atoms at the lateral sides of the flattened base tip 44 are removed and a sharpened tip 45 which may include a single atom at the apex thereof is formed. At least tip 45 is annealed to recover the apex and to result in an ultra sharp tip, for example, a single atom tip 46 covered by a monolayer of platinum atoms, as shown in Fig. 7d.

Consequently, in the step of locally removing the coating in examples of the method according to embodiments disclosed herein, there is additionally the option to shape the apex region of the base tip. Shaping, e.g. changing the given tip geometry to a more favorable one, can be, for instance, flattening by further field evaporation, sharpening by spatially controlled field-assisted reaction with nitrogen, and/or thermally induced shaping. Moreover, by utilizing these shaping processes, the surface roughness of the final ultra sharp tip or of the final single atom tip, respectively, may be minimized, providing an atomic smooth surface thereof. These options open the possibility to optimize the crucial base tip geometry at the apex which can remarkably enhance the performance of the tip as electron or ion emitter.

Other examples of the method according to embodiments disclosed herein, may further comprise at least one step selected from the group consisting of partially removing atoms at the uppermost apex by field evaporation, and forming a protective coating on the tip and subsequently partially removing a protective coating at the uppermost apex by field evaporation.

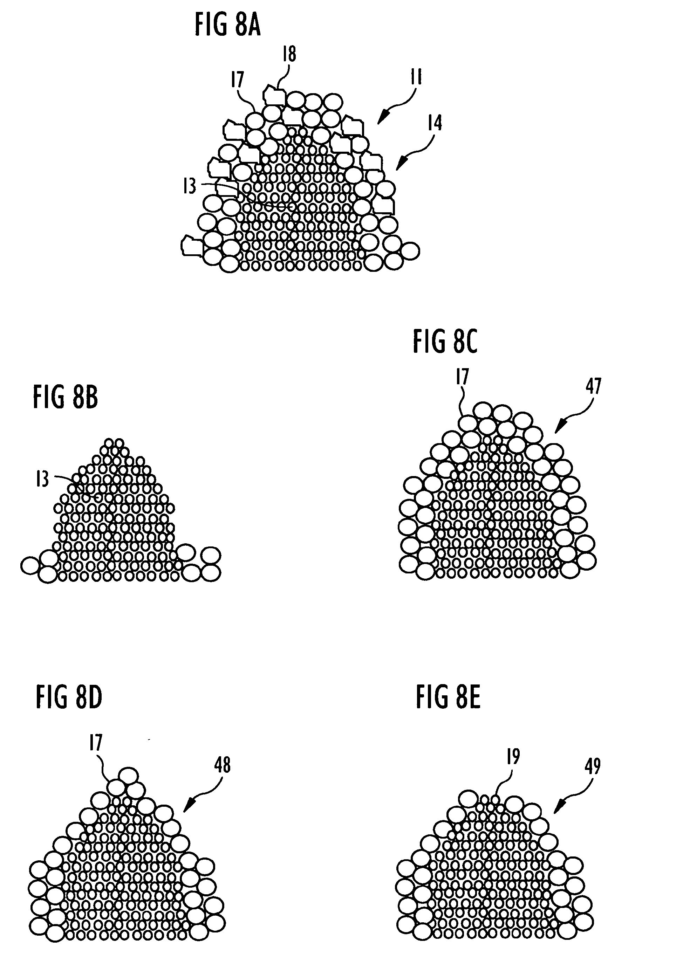

Typical intermediates and a typical product of a yet further example of the method disclosed herein are shown in Figs. 8a to 8d. According to this example, atoms at the uppermost apex are removed by field evaporation in an additional step. At first, the three steps of the above example described with respect to Figs. 2a to 2c are performed. That means, a precursor tip 11 having a tungsten base tip 13 and a platinum layer 14 is provided as shown in Fig. 8a, platinum atoms 17 and contaminants 18 at the apex are removed by field evaporation, and the exposed apex of the base tip 13 shown in Fig. 8b is recovered by, e.g. two, platinum layers, e.g. by annealing, resulting in a clean platinum covered ultra sharp tip 47 illustrated in Fig. 8c. Thereafter, platinum atoms 17 of the top platinum layer are removed from the apex of the ultra sharp tip 47, typically by field evaporation, which may result in a single atom tip 48 having an apex covered by a platinum monolayer as shown in Fig. 8d.

Additionally, in a variation of the present example, further platinum atoms 17 may be removed from the uppermost apex of the ultra sharp tip 48 by field evaporation, such that some tungsten atoms 19 of the base tip 13 are exposed as shown in Fig. 8e. Thereby, an ultra sharp tip 49 may be produced having at the uppermost apex both tungsten atoms 19 and platinum atoms 17. Such an ultra sharp tip 49 may be suitable for specific electron or ion source applications requiring an adapted electron or ion current.

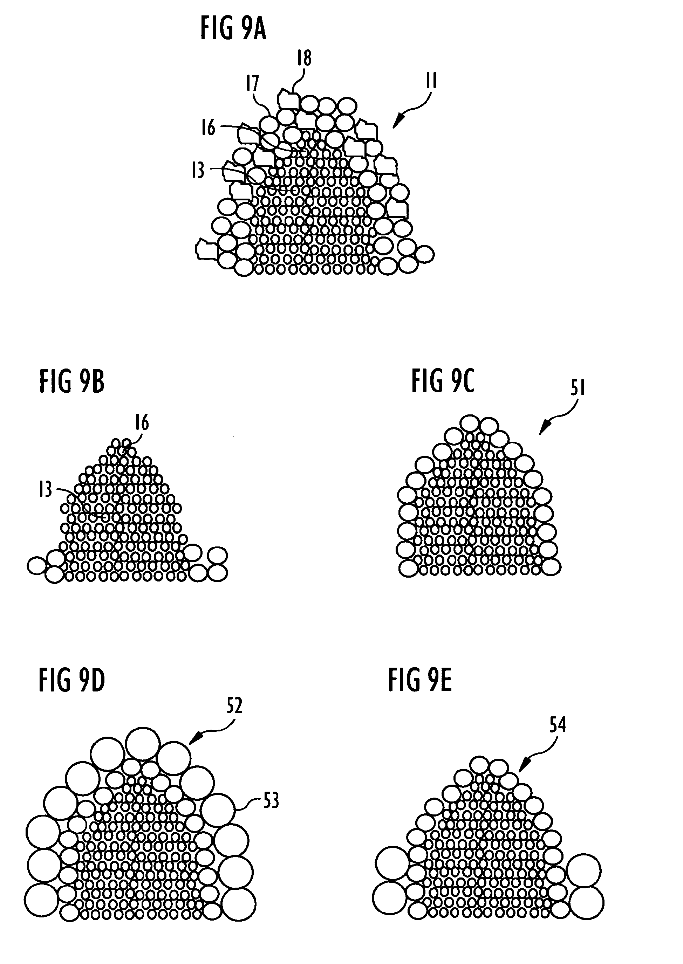

Directed to another example of a method disclosed herein, Figs. 9a to 9e illustrate typical intermediates and a typical product thereof. In this example the method includes the steps of forming a protective coating on the tip and subsequently partially removing a protective coating at the uppermost apex by field evaporation. The initial three steps of this method correspond to the steps of the example described with respect to Figs. 4a to 4c. That means that at first a platinum covered precursor tip 11 is provided, and then field evaporation is performed on the platinum covered tip 11, in order to evaporate platinum atoms 17 and contaminants 18 and to expose the apex 16 of the base tip 13. Thereafter, for restoring the coating, the tip is annealed and a monolayer of platinum atoms may be formed on the apex 16 of the base tip 13, resulting in an ultra sharp tip 51 shown in Fig. 9c, which is covered by a monolayer of platinum. Subsequently, a protective layer 52 including protective atoms or protective molecules 53 may be applied on the platinum monolayer. Then, the protective layer may be removed exclusively at the apex, e.g. by field evaporation. The protective atoms or molecules 53 typically may have melting and boiling points which are lower than the ones of platinum and tungsten. The material of the protective layer may, for instance, be another metal, such as Pd, Ir, Cu, Ag, Au or Al, a metal alloy or metal oxide(s). Using the present example, an ultra sharp tip 54 or even a single atom tip may be produced, having an apex covered by a monolayer of platinum and further having a protective layer disposed on the platinum monolayer at the shank of the tip 54. Ultra sharp tip 54 may therefore be used in applications requiring for example a highly aggressive or corrosive gas ambient, e.g. in a plasma.

Hence, a further optional step in examples of the method according to embodiments disclosed herein can be the partial removal of atoms at the uppermost apex of the ultra sharp tip, e.g. an emitter tip, by field evaporation. In some cases it might be beneficial to cover in another optional step the shank of an emitter tip with a protective layer to avoid reactions with contaminants. This can be done by first covering the whole emitter tip, as described above, and then removing the cover at the very tip by field evaporation.

In the above examples of the method according to embodiments described herein, the initial step of providing a precursor tip 11, which typically may be a tungsten base tip 13 covered by a platinum coating 14, may include depositing the coating on the tip in a deposition device and mounting the coated tip in a vacuum chamber. In this case, the vacuum chamber may include the components for performing the subsequent method steps, i.e. a tip support, a field evaporation device adapted for performing field evaporation at a tip provided at the tip support, and a coating restoring device. Moreover, the step of providing the precursor tip may include depositing the coating on the tip by at least one procedure selected from the group consisting of physical vapor deposition, electrolytic deposition, electroplating, and chemical vapor deposition. According to these examples of the method, it is not required that the step of providing is conducted under clean conditions, since contaminants which may be adsorbed at the apex of the precursor tip or may be incorporated into the coating of the precursor tip will be removed during the subsequent method step of field evaporation.

According to another alternative of the method according to embodiments described herein, in the initial step of providing a precursor tip 11, commercially available plating covered tungsten tips may be used and installed in a vacuum chamber for performing the subsequent method steps. Possible contaminations of a commercial tip will be reduced or eliminated in the subsequent steps of locally removing the coating by field evaporation.

Alternatively, in the method according to embodiments described herein, the preparation of the precursor tip 11, e.g. the covering of the tungsten base tip 13 by the platinum coating 14, may be conducted directly in the vacuum chamber for performing the further method steps of field evaporation and restoring of the coating. In this alternative, a precursor tip 11 may be provided having a negligible amount of contaminants adsorbed or incorporated into the platinum layer.

The above description is directed to a tungsten base tip covered by a platinum coating. However, as the skilled person knows, other combinations of materials, e.g. other metal combinations, may be used. For instance, the materials may have a suitable wettability with respect to each other. That means, the selected combination of materials may typically result in a minimization of the surface energy (also referred to as surface tension), when the material of the base tip is covered by the coating material. Thereby, a partial or full coverage during the step of restoring the coating may be ensured and adsorbate induced faceting may be promoted. Moreover, an appropriate migration of the coating atoms to and at the exposed apex of the base tip during the step of restoring, e.g. during annealing, may typically be provided by the selected combination of materials. Furthermore, the melting and boiling points of the coating material may typically be lower than the ones of the base tip material of the selected material combination. In one example, in the method according to embodiments described herein, the tip is a metal tip and the coating is a noble metal coating. Hence, in the method according to embodiments described herein, the metal tip may comprise at least one refractory metal selected from the group consisting of W, Ta, Mo, Nb, Re, and the noble metal coating may comprise at least one noble metal selected from the group Pt, Pd, Rh, Ru, Au. Other noble metals which may be contemplated as coating materials are Cu, Ag, and Ir. Furthermore, even alloys, e.g. alloys of the above mentioned noble metals, may come into consideration as coating materials.

In a further example of the method according to embodiments disclosed herein, at least the steps of locally removing and partially or fully restoring may be performed while the tip is provided in a charged particle column, the tip being provided in a position to perform probing or structuring of a specimen. In another example of the method according to embodiments described herein, the ultra sharp tip is for an electron or ion source and at least the steps of locally removing and partially or fully restoring are performed while the ultra sharp tip is provided in the electron or ion source, e.g. the tip support being a tip support of the electron or ion source. These examples allows for conducting the method of preparing an ultra sharp tip, particularly a single atom tip, in situ, typically directly in the installation the tip is produced for. Furthermore, at least the method steps of locally removing the coating from the apex by field evaporation and partially or fully restoring the coating at the apex may be repeated directly in the installation of the electron or ion source, in order to reproduce the ultra sharp tip in case of exhaustion, contamination or damage thereof. As the skilled person knows, when using an electron source as tip support, for performing field evaporation, the polarity of the tip may simply be reversed.

As mentioned above, Fig. 1a schematically shows an example of an apparatus for preparing an ultra sharp tip described herein. However, any other vacuum chamber comprising a tip support, a field evaporation device adapted for performing field evaporation at a tip provided at the tip support, and a coating restoring device may be used as an apparatus for preparing an ultra sharp tip described herein. Further examples of an apparatus for preparing an ultra sharp tip disclosed herein are installations including an electron or ion source, e.g. an ion beam pattern generator or an electron microscope. Other vacuum setups for performing the preparation steps of field evaporation and restoring of the coating according to the method of embodiments described herein can be e.g. a gas field ion source or a field ion microscope. In such setups, the ultra sharp tips described herein may not only be prepared, but may also be used as beam emitters, for instance as electron or ion sources, as mentioned above. Moreover, use of a field ion microscope as an apparatus for preparing an ultra sharp tip enables, in addition, easy monitoring and control of the tip quality.

Fig. 1b shows a gas field ion source as another example of an apparatus for preparing an ultra sharp tip described herein. Typically, a gas field ion source for generating an ion beam comprises a vacuum chamber including an ion point source and an optical column. Ion formation in a gas field ion source is based on ion formation at the very tip of an emitter unit of the ion point source in a gas ambient. The emitter tip may be biased at e.g. 10 kV positive with respect to a downstream extractor unit including an extraction aperture for producing an electric field strong enough to ionize the gas atoms in the vicinity of the emitter unit.

In the example shown in Fig. 1b, the gas field ion source is formed as a vacuum chamber 10 provided with an emitter unit 30 and a tip 50. In this example, emitter unit 30 acts as the tip support for tip 50. Emitter unit 30 is connected via connections 81 and 82 to a current supply 80 for applying a high voltage as well as a heating current to the tip 50, thereby forming the coating restoring device of this example. The vacuum chamber 10 further includes an extractor unit 20 for extracting and accelerating ions produced at the tip 50 during operation of the gas field ion source. The extractor unit 20 may also be used as the field evaporation device for performing field evaporation at the tip 50.

In operation of the gas field ion source as such, gas is directed to tip 50. Extractor unit 20 effects the extraction and the acceleration of the ions from the tip. Typically, the extractor unit 20 may also serve for separating the source from the rest of the optical column. The ions form an ion beam 70 that moves along the optical axis 60 through an extraction aperture of the extractor unit 20. For the purpose of inspection of a specimen 90, the ion beam current is typically in the range between 1 pA and 100 nA, depending on the kind of specimen and the spatial resolution needed. The ions impinge on the specimen 90. Depending on the application, secondary particles 100 may be generated during the interaction of the ions with the specimen material. For instance, the secondary particles 100 may be electrons. In an inspecting or imaging application, the secondary particles such as the electrons are detected, e.g. by using a detector such as a pin diode or the like. In general, the specimen can be any physical body that is meant to be inspected or structured with high spatial resolution. Typically, the spatial resolution is high enough to resolve structures in the sub-micron range. In particular, the specimen can be a semiconductor wafer, an integrated circuit device, a micromechanical device, a data storage device or biological tissue. The spatial resolution may be further improved when an ultra sharp tip or a single atom tip described herein is used in the emitter unit 30 of the gas field ion source 10.

As mentioned above, the gas field ion source shown in Fig. 1b may be used for preparing an ultra sharp tip in an example of methods according to embodiments disclosed herein. Tip 50 is in this case the above mentioned precursor tip and may be a commercial tip for ion source applications. In the present example tip 50 includes a tungsten base tip covered by a platinum coating, and is mounted in a first step of the present method at the emitter unit 30 used as tip support. Then, in a second method step the platinum coating is locally removed from the apex using field evaporation, by increasing the electrical field applied between the tip 50 and the extractor unit 20 until evaporation of the tip atoms occurs. After having removed the upper layers locally at the apex as desired, the electric field is shut down. In a subsequent step, the coating is restored on the apex partially or fully, e.g. by annealing such that the platinum atoms, which remained at the shank of the tip 50 after field evaporation, migrate and recover the apex. Thereby, a sub-monolayer, a monolayer or several layers of platinum atoms may be formed at the apex, resulting in an ultra sharp tip or even a single atom tip.

As a result, the method according to embodiments described herein provides, well controlled, fully or shank covered ultra sharp tips or even single atom tips (SAT) with appropriate tip shape and superior cleanness. The method of the examples and embodiments described herein is not limited to tungsten base tips or any special coating material as long as proper wetting of the base tip surface by the coating material is provided.

In one example useful for understanding the invention, a method of preparing an ultra sharp tip, in particular a single atom tip, is provided, the method comprising: providing a tip having a shank, an apex, and a coating covering the shank and the apex; locally removing the coating from the apex by field evaporation; and restoring the coating at the apex.

In a modification of the above example useful for understanding the invention, the step of restoring the coating is performed partially.

In a modification of any of the above example useful for understanding the invention and modification thereof, the step of restoring the coating is performed fully.

In a modification of any of the above example useful for understanding the invention and modifications thereof, the step of restoring the coating is performed by annealing the tip.

In a modification of any of the above example useful for understanding the invention and modifications thereof, in the step of restoring the coating at least a monolayer of the coating is formed on the apex.

In a modification of any of the above example useful for understanding the invention and modifications thereof, at least the steps of locally removing the coating and restoring the coating are performed in a vacuum chamber.

In a modification of any of the above example useful for understanding the invention and modifications thereof, at least the steps of locally removing the coating and restoring the coating are performed in a vacuum chamber.

In a modification of any of the above example useful for understanding the invention and modifications thereof, at least one of the steps of locally removing the coating and restoring the coating are performed in situ. Typically, the steps of locally removing the coating and restoring the coating may be performed in situ of an apparatus the ultra sharp tip is prepared for.

In a modification of any of the above examples, embodiments and modifications thereof, at least the steps of locally removing and restoring are performed while the tip is provided in a charged particle column, the tip being provided in a position to perform probing or structuring of a specimen.

In a modification of any of the above example useful for understanding the invention and modifications thereof, in the step of locally removing the coating, the apex is shaped by at least one step selected from the group consisting of flattening by field evaporation, and, according to the present invention, sharpening by spatially controlled field-assisted etching.

A modification of any of the above example or embodiment and modifications thereof further comprises at least one step selected from the group consisting of partially removing atoms at the uppermost apex by field evaporation, and forming a protective coating on the tip and subsequently partially removing a protective coating at the uppermost apex by field evaporation.

In a modification of any of the above embodiment or example and modifications thereof, the step of providing comprises depositing the coating on the tip by at least one procedure selected from the group consisting of physical vapor deposition, electrolytic deposition, electroplating, and chemical vapor deposition.

In a modification of any of the above embodiment or example and modifications thereof, the step of providing comprises depositing the coating on the tip in a deposition device and mounting the coated tip in a vacuum chamber for preparing an ultra sharp tip.

In a modification of any of the above embodiment or example and modifications thereof, the ultra sharp tip is for an ion source and at least the steps of locally removing and annealing are performed while the ultra sharp tip is provided in the ion source.

In a modification of any of the above embodiment or example and modifications thereof, the ultra sharp tip is for an electron source and at least the steps of locally removing and annealing are performed while the ultra sharp tip is provided in the electron source.

In a modification of any of the above embodiment or example and modifications thereof, the step of restoring may be performed by at least one step selected from the group consisting of heating by applying a current to the tip, heating by laser irradiation, and deposition of additional coating material.

In a modification of any of the above embodiment or example and modifications thereof, the tip is a single crystal tip.

In a modification of any of the above embodiment or example and modifications thereof, the tip is a metal tip and the coating is a noble metal coating.

In a modification of any of the above embodiment or example and modifications thereof, the metal tip comprises at least one refractory metal selected from the group consisting of W, Ta, Mo, Nb, Re; and the noble metal coating comprises at least one noble metal selected from the group Pt, Pd, Rh, Ru, Au.

Further, it is provided an apparatus for preparing an ultra sharp tip, in particular a single atom tip, comprising a vacuum chamber comprising a tip support; a field evaporation device adapted for performing a field evaporation at a tip provided at the tip support; and a coating restoring device.

In a modification of the above, the coating restoring device comprises at least one element selected from the group of a resistance heating device adapted for applying a current to the tip, a laser adapted for heating the tip, and a coating device adapted for coating the tip.

In a modification of any of the above and modification thereof, the tip support is a tip support of an electron source.

In a modification of any of the above and modifications thereof, the tip support is a tip support of an ion source.

In a modification of any of the above and modifications thereof, the vacuum chamber comprises at least one element selected from the group consisting of a gas field ion source, an ion beam pattern generator, an electron source, field ion microscope, an electron microscope, and a coating device.

In other embodiments, it is provided a use of any of the above and modifications thereof in a method for preparing an ultra sharp tip, according to claim 1.

The written description uses examples to disclose the invention, including the best mode, and also to enable any person skilled in the art to make and use the invention. While the invention has been described in terms of various specific embodiments, those skilled in the art will recognize that the invention can be practiced with modifications within the scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A method of preparing an ultra sharp tip, in particular a single atom tip, comprising:
providing a tip (11) having a shank (15), an apex (16), and a coating (14) covering the shank and the apex;
exposing the apex by locally removing the coating (14) from the apex (16) by field evaporation; and
partially or fully restoring the coating at the apex (16),
wherein in the step of locally removing the coating, the apex (16) is shaped by sharpening by spatially controlled field-assisted etching.

2. The method according to claim 1, wherein the step of partially or fully restoring is performed by annealing the tip, optionally such that at least a monolayer of the coating is formed on the apex.

3. The method according to claim 1 or 2, wherein at least the steps of locally removing and partially or fully restoring are performed in a vacuum chamber (1; 10), optionally in situ.

4. The method according to any of the preceding claims, wherein in the step of locally removing the coating, the apex (16) is further shaped by at least one step selected from the group consisting of thermally induced shaping, and flattening by field evaporation.

5. The method according to any of the preceding claims, further comprising at least one step selected from the group consisting of partially removing atoms at the uppermost apex by field evaporation, and forming a protective coating on the tip and subsequently partially removing the protective coating at the uppermost apex by field evaporation.

6. The method according to any of the preceding claims, wherein the step of providing comprises depositing the coating on the tip by at least one procedure selected from the group consisting of physical vapor deposition, electrolytic deposition, electroplating, and chemical vapor deposition.

7. The method according to any of the preceding claims, wherein the step of providing comprises depositing the coating on the tip in a deposition device and mounting the coated tip in a vacuum chamber for preparing an ultra sharp tip.

8. The method according to any of the preceding claims, wherein at least the steps of locally removing and partially or fully restoring are performed
a) while the tip is provided in a charged particle column, the tip being provided in a position to perform probing and/or structuring of a specimen, and/or
b) while the tip is provided in the electron or ion source the ultra sharp tip is produced for.

9. The method according to any of the preceding claims, wherein
the step of partially or fully restoring is performed by at least one step selected from the group consisting of heating by applying a current to the tip, heating by laser irradiation, and deposition of additional coating material.

10. The method according to any of the preceding claims, wherein the tip is at least one element selected from the group consisting of a single crystal tip; a metal tip, the coating being a noble metal coating; a metal tip comprising at least one refractory metal selected from the group consisting of W, Ta, Mo, Nb, Re, the coating comprising at least one noble metal selected from the group consisting of Pt, Pd, Rh, Ru, Au, Ir, Cu, Ag.

11. The use of an apparatus for preparing an ultra sharp tip, in particular a single atom tip, the apparatus comprising
a vacuum chamber (1; 10) comprising
a tip support (3; 30);
a field evaporation device (2) adapted for exposing the apex by performing a field evaporation at a tip (11; 50) provided at the tip support (3; 30);
and a coating restoring device (8),
wherein the ultra sharp tip is prepared according to the method of claim 1.

12. The use of claim 11, wherein the coating restoring device (8) comprises at least one element selected from the group of a resistance heating device adapted for applying a current to the tip, a laser adapted for heating the tip, and a coating device adapted for coating the tip.

13. The use of claim 11 or 12, wherein the tip support (3; 30) is a tip support of an electron or ion source.

14. The use of any of claims 11 to 13, wherein the vacuum chamber (1; 10) comprises at least one element selected from the group consisting of a gas field ion source, an ion beam pattern generator, an electron source, field ion microscope, an electron microscope, and a coating device.

## Patentansprüche

1. Verfahren zur Herstellung einer ultrascharfen Spitze, insbesondere einer Einzelatomspitze, Folgendes umfassend:
Bereitstellen einer Spitze (11) mit einem Schaft (15), einem Scheitelpunkt (16) und einer den Schaft und den Scheitelpunkt bedeckenden Beschichtung (14);
Freilegen des Scheitelpunkts durch lokales Entfernen der Beschichtung (14) vom Scheitelpunkt (16) durch Feldverdampfung; und
teilweises oder vollständiges Wiederherstellen der Beschichtung am Scheitelpunkt (16),
wobei im Schritt des lokalen Entfernens der Beschichtung, der Scheitelpunkt (16) durch Schärfen mittels räumlich gesteuerten feldunterstützten Ätzens geformt wird.

2. Verfahren nach Anspruch 1, wobei der Schritt des teilweisen oder vollständigen Wiederherstellens durch Anlassen der Spitze optional derart erfolgt, dass sich zumindest eine Monoschicht der Beschichtung auf dem Scheitelpunkt bildet.

3. Verfahren nach Anspruch 1 oder 2, wobei zumindest die Schritte des lokalen Entfernens und teilweisen oder vollständigen Wiederherstellens in einer Vakuumkammer (1; 10) optional vor Ort erfolgen.

4. Verfahren nach einem der vorhergehenden Ansprüche, wobei im Schritt des lokalen Entfernens der Beschichtung der Scheitelpunkt (16) darüber hinaus durch mindestens einen Schritt geformt wird, der aus der Gruppe ausgewählt ist, die aus wärmeinduzierter Formgebung und Abflachen durch Feldverdampfung besteht.

5. Verfahren nach einem der vorhergehenden Ansprüche, darüber hinaus mindestens einen Schritt umfassend, der aus der Gruppe ausgewählt ist, die aus teilweisem Entfernen von Atomen am obersten Scheitelpunkt durch Feldverdampfung und Ausbilden einer Schutzbeschichtung an der Spitze und anschließendem teilweisem Entfernen der Schutzbeschichtung am obersten Scheitelpunkt durch Feldverdampfung besteht.

6. Verfahren nach einem der vorhergehenden Ansprüche, wobei der Schritt des Bereitstellens ein Abscheiden der Beschichtung auf der Spitze durch zumindest einen Vorgang umfasst, der aus der Gruppe ausgewählt ist, die aus physikalischem Aufdampfen, elektrolytischer Abscheidung, Galvanisieren und chemischer Dampfphasenabscheidung besteht.

7. Verfahren nach einem der vorhergehenden Ansprüche, wobei der Schritt des Bereitstellens ein Abscheiden der Beschichtung auf der Spitze in einer Abscheidungsvorrichtung und Aufstellen der beschichteten Spitze in einer Vakuumkammer umfasst, um eine ultrascharfe Spitze herzustellen.

8. Verfahren nach einem der vorhergehenden Ansprüche, wobei zumindest die Schritte des lokalen Entfernen und teilweisen oder vollständigen Wiederherstellens erfolgen
a) während die Spitze in einer Ladungspartikelsäule vorgesehen ist, wobei die Spitze in einer Stellung zum Durchführen einer Sondierung und/oder Strukturierung einer Probe vorgesehen ist, und/oder
b) während die Spitze in der Elektronen- oder Ionenquelle vorgesehen ist, für welche die ultrascharfe Spitze hergestellt ist.

9. Verfahren nach einem der vorhergehenden Ansprüche, wobei der Schritt des teilweisen oder vollständigen Wiederherstellens durch mindestens einen Schritt erfolgt, der aus der Gruppe ausgewählt ist, die aus Erwärmen durch Anlegen eines Stroms an die Spitze, Erwärmen durch Laserbestrahlung und Abscheiden zusätzlichen Beschichtungsmaterials besteht.

10. Verfahren nach einem der vorhergehenden Ansprüche, wobei es sich bei der Spitze um mindestens eine Komponente handelt, die aus der Gruppe ausgewählt ist, die aus einer Einkristallspitze; einer Metallspitze, wobei die Beschichtung eine Edelmetallbeschichtung ist; einer Metallspitze mit mindestens einem hochschmelzenden Metall besteht, das aus der Gruppe ausgewählt ist, die aus W, Ta, Mo, Nb, Re ausgewählt ist, wobei die Beschichtung mindestens ein Edelmetall umfasst, das aus der Gruppe ausgewählt ist, die aus Pt, Pd, Rh, Ru, Au, Ir, Cu, Ag besteht.

11. Verwendung einer Vorrichtung zur Herstellung einer ultrascharfen Spitze, insbesondere einer Einzelatomspitze, wobei die Vorrichtung umfasst:
eine Vakuumkammer (1; 10) mit
einer Spitzenhalterung (3; 30);
einer zum Freilegen des Scheitelpunkts ausgelegten Feldverdampfungsvorrichtung (2) durch Durchführen einer Feldverdampfung an einer Spitze (11; 50), die an der Spitzenhalterung (3; 30) vorgesehen ist;
und einer Beschichtungswiederherstellungsvorrichtung (8),
wobei die ultrascharfe Spitze nach dem Verfahren von Anspruch 1 hergestellt wird.

12. Verwendung nach Anspruch 11, wobei die Beschichtungswiederherstellungsvorrichtung (8) mindestens eine Komponente umfasst, die aus der Gruppe ausgewählt ist, die aus einer zum Anlegen eines Stroms an die Spitze ausgelegten Widerstandserwärmungsvorrichtung, eines zum Erwärmen der Spitze ausgelegten Lasers und einer zum Beschichten der Spitze ausgelegten Beschichtungsvorrichtung besteht.

13. Verwendung nach Anspruch 11 oder 12, wobei es sich bei der Spitzenhalterung (3; 30) um eine Spitzenhalterung einer Elektronen- oder Ionenquelle handelt.

14. Verwendung nach einem der Ansprüche 11 bis 13, wobei die Vakuumkammer (1; 10) mindestens eine Komponente umfasst, die aus der Gruppe ausgewählt ist, die aus einer Gasfeldionenquelle, einem Ionenstrahlstrukturgenerator, einer Elektronenquelle, einem Feldionenmikroskop, einem Elektronenmikroskop und einer Beschichtungsvorrichtung besteht.

## Revendications

1. Procédé de réalisation d'une pointe ultra acérée, en particulier d'une pointe d'un seul atome, comprenant :
la mise à disposition d'une pointe (11) ayant une tige (15), un apex (16), et un revêtement (14) couvrant la tige et l'apex ;
l'exposition de l'apex par enlèvement local du revêtement (14) de l'apex (16) par évaporation de champ ; et
le rétablissement partiel ou entier du revêtement sur l'apex (16),
où, à l'étape d'enlèvement local du revêtement, l'apex (16) est formé par affûtage par gravure assistée par champ à commande spatiale.

2. Le procédé selon la revendication 1, où l'étape de rétablissement partiel ou entier est effectuée par recuit de la pointe, facultativement de telle sorte qu'au moins une monocouche du revêtement se forme sur l'apex.

3. Le procédé selon la revendication 1 ou 2, où au moins les étapes d'enlèvement local et de rétablissement partiel ou entier sont effectuées dans une chambre à vide (1 ; 10), facultativement in situ.

4. Le procédé selon l'une quelconque des revendications précédentes, où, à l'étape d'enlèvement local du revêtement, l'apex (16) est en outre formé par au moins une étape sélectionnée dans le groupe constitué par le formage induit thermiquement et l'aplatissement par évaporation de champ.

5. Le procédé selon l'une quelconque des revendications précédentes, comprenant en outre au moins une étape sélectionnée dans le groupe constitué par l'enlèvement partiel d'atomes sur l'apex supérieur par évaporation de champ, et la formation d'un revêtement protecteur sur la pointe et l'enlèvement partiel consécutif du revêtement protecteur sur l'apex supérieur par évaporation de champ.

6. Le procédé selon l'une quelconque des revendications précédentes, où l'étape de mise à disposition comprend le dépôt du revêtement sur la pointe par au moins un procédé sélectionné dans le groupe constitué par le dépôt physique de vapeur, le dépôt électrolytique, l'électroplacage, et le dépôt chimique de vapeur.

7. Le procédé selon l'une quelconque des revendications précédentes, où l'étape de mise à disposition comprend le dépôt du revêtement sur la pointe dans un appareil de dépôt et le montage de la pointe revêtue dans une chambre à vide pour la réalisation d'une pointe ultra acérée.

8. Le procédé selon l'une quelconque des revendications précédentes, où au moins les étapes d'enlèvement local et de rétablissement partiel ou entier sont effectuées
a) lorsque la pointe est mise à disposition dans une colonne de particules chargées, la pointe étant mise à disposition dans une position pour réaliser le sondage et/ou la structuration d'un échantillon, et/ou
b) lorsque la pointe est mise à disposition dans la source d'électrons ou d'ions pour laquelle la pointe ultra acérée est produite.

9. Le procédé selon l'une quelconque des revendications précédentes, où l'étape de rétablissement partiel ou entier est effectuée par au moins une étape sélectionnée dans le groupe constitué par le chauffage par application d'un courant à la pointe, le chauffage par irradiation laser, et le dépôt de matière de revêtement additionnelle.

10. Le procédé selon l'une quelconque des revendications précédentes, où la pointe est au moins un élément sélectionné dans le groupe constitué par une pointe d'un seul cristal ; une pointe métallique, le revêtement étant un revêtement métallique noble ; une pointe métallique comprenant au moins un métal réfractaire sélectionné dans le groupe constitué par W, Ta, Mo, Nb, Re, le revêtement comprenant au moins un métal noble sélectionné dans le groupe constitué par Pt, Pd, Rh, Ru, Au, Ir, Cu, Ag.

11. L'utilisation d'un dispositif destiné à réaliser une pointe ultra acérée, en particulier une pointe d'un seul atome, le dispositif comprenant
une chambre à vide (1 ; 10) comprenant
un support de pointe (3 ; 30) ;
un appareil d'évaporation de champ (2) apte à exposer l'apex en effectuant une évaporation de champ sur une pointe (11 ; 50) mise à disposition sur le support de pointe (3 ; 30) ;
et un appareil de rétablissement de revêtement (8),
où la pointe ultra acérée est réalisée selon le procédé de la revendication 1.

12. L'utilisation de la revendication 11, où l'appareil de rétablissement de revêtement (8) comprend au moins un élément sélectionné dans le groupe constitué par un appareil de chauffage par résistance apte à appliquer un courant à la pointe, un laser apte à chauffer la pointe, et un appareil de revêtement apte à revêtir la pointe.

13. L'utilisation de la revendication 11 ou 12, où le support de pointe (3 ; 30) est un support de pointe d'une source d'électrons ou d'ions.

14. L'utilisation de l'une quelconque des revendications 11 à 13, où la chambre à vide (1 ; 10) comprend au moins un élément sélectionné dans le groupe constitué par une source d'ions à champ de gaz, un générateur de structure de faisceaux d'ions, une source d'électrons, un microscope à ions de champ, un microscope à électrons, et un appareil de revêtement.
